(19) Europäisches Patentamt

European Patent Office

Office européen des brevets

(11) **EP 1 333 293 B1**

(12) **EUROPÄISCHE PATENTSCHRIFT**

(45) Veröffentlichungstag und Bekanntmachung des Hinweises auf die Patenterteilung:
**20.12.2006 Patentblatt 2006/51**

(51) Int Cl.:
*G01R 31/3185* (2006.01)    *G05B 19/418* (2006.01)
*H01L 21/66* (2006.01)

(21) Anmeldenummer: **03002315.4**

(22) Anmeldetag: **03.02.2003**

(54) **Verfahren zur Fehleranalyse in der Waferfertigung**

Method for failure analysis in the wafer fabrication

Procédé pour l'analyse des défaillances durant la fabrication de plaquettes de semi-conducteur

(84) Benannte Vertragsstaaten:
**DE FR IT**

(30) Priorität: **04.02.2002 DE 10204426**

(43) Veröffentlichungstag der Anmeldung:
**06.08.2003 Patentblatt 2003/32**

(73) Patentinhaber: **Infineon Technologies AG**
**81669 München (DE)**

(72) Erfinder: **Pöppel, Gerhard**
**93049 Regensburg (DE)**

(74) Vertreter: **Ginzel, Christian et al**
**Zimmermann & Partner,**
**Postfach 33 09 20**
**80069 München (DE)**

(56) Entgegenhaltungen:
US-A- 5 497 381        US-A- 5 793 650
US-A- 5 838 951        US-A- 5 991 699
US-B1- 6 392 434       US-B1- 6 393 602
US-B1- 2002 156 550

• HESS C ET AL: "Wafer level defect density distribution using checkerboard test structures" 23. März 1998 (1998-03-23), MICROELECTRONIC TEST STRUCTURES, 1998. ICMTS 1998., PROCEEDINGS OF THE 1998 INTERNATIONAL CONFERENCE ON KANAZAWA, JAPAN 23-26 MARCH 1998, NEW YORK, NY, USA,IEEE, US, PAGE(S) 101-106 , XP010291082 ISBN: 0-7803-4348-4 * Seite 101 - Seite 103 *
• FRIEDMANN ET AL: "Model-Free estimation of defect clustering in integrated circuit fabrication" IEEE TRANSACTIONS ON SEMICONDUCTOR MANUFACTURING, Bd. 10, Nr. 3, 1997, Seiten 344-359, XP002289503

**Beschreibung**

Die vorliegende Erfindung betrifft ein Verfahren zur Fehleranalyse in der Waferfertigung. Die vorliegende Erfindung betrifft insbesondere ein Verfahren zur Fehleranalyse zur Verwendung für die Produktion von integrierten Halbleiterprodukten.

In der Regel werden integrierte Halbleiterprodukte mit Hilfe von sogenannten "Wafern" hergestellt. Ein Wafer ist üblicherweise in eine Vielzahl von sogenannten Chips unterteilt, die schließlich am Ende der Produktion, insbesondere nach dem Zersägen des Wafers, den integrierten Halbleiterprodukten entsprechen. Die Größe der einzelnen Chips und die Anzahl der Chips pro Wafer ist dabei im wesentlichen durch das Design und die Art des herzustellenden Halbleiterprodukts vorgegeben. Das Design und die Art des herzustellenden Halbleiterprodukts bestimmen weiterhin, welcher Herstellungsprozess von dem Wafer durchlaufen wird.

Am Ende der Herstellung werden die Chips schließlich daraufhin getestet, ob die Chips funktionieren oder nicht. Diese Tests werden in der Regel durchgeführt bevor der Wafer zersägt wird. In diesem Zusammenhang ist das Verhältnis der funktionierenden Chips zu der Gesamtzahl der hergestellten Chips einer der wesentlichen Parameter. Dieser Parameter bestimmt zu einem wesentlichen Teil die Wirtschaftlichkeit der gesamten Produktion.

Darüber hinaus werden die Ergebnisse der Tests für Fehleranalysen verwendet. So soll beispielsweise herausgefunden werden, ob während der Herstellung systematische Fehler auftreten oder ob das Design des herzustellenden Halbleiterprodukts systematische Fehler bzw. Schwächen aufweist. Ist das Vorhandensein eines derartigen Fehlers erkennbar, wäre es natürlich wünschenswert, wenn auch die Fehlerquelle ermittelt werden könnte.

Ausgangspunkt für entsprechende Fehleranalysen ist in der Regel eine sogenannte "MultipleChip-Analyse" ("MultipleWindow-Analyse"), bei der in mehreren Schritten aus den auf dem Wafer vorhandenen Chips immer größere, fiktive Chips gebildet werden. Ein derartiger fiktiver Chip, der sich aus einer vorgegebenen Anzahl benachbarter realer Chips zusammensetzt, wird als funktionierender Chip angesehen, wenn alle realen Chips, aus denen er aufgebaut ist, funktionieren. Ist hingegen nur einer dieser realen Chips fehlerhaft, so auch der fiktive Chip als fehlerhaft angesehen. Aus den so gewonnen Daten kann dann, unter bestimmten Modellannahmen, die sogenannte elektrisch wirksame Defektdichte bestimmt werden, welche für weitergehende Analysen wichtig ist.

Leider treten bei der Anwendung der MultipleChip-Analyse eine Reihe Schwierigkeiten auf. So kommt es beispielsweise bei bestimmten, relativ regelmäßigen Anordnungen der fehlerhaften Chips auf dem Wafer (sogenannte "Declustered-Fails") zu Fehlinterpretationen, da solche Anordnungen in der Regel nicht korrekt erkannt werden. Darüber hinaus können derartige regelmäßige Anordnungen, die nur auf einen Teil des Wafers beschränkt sind, die korrekte Erkennung von "normalen" Fehleranordnungen (sogenannte "Clustered-Fails") negativ beeinflussen, da es zu einer Art Kompensation zwischen Declustered-Fails und Clustered-Fails kommen kann.

In der Praxis muß zur Bestimmung der elektrisch wirksame Defektdichte häufig eine Regression durchgeführt, was wiederum zu fehlerhaften Ergebnissen führen kann. Darüber hinaus können die Ergebnisse von der Anzahl der Schritte abhängen, die zu den immer größer werdenden, fiktiven Chips führen, und von der Art und Weise, wie die realen Chips zu den fiktiven Chips zusammengefaßt werden. Ferner ist die Anzahl der fiktiven Chips abhängig von der Anzahl der realen Chips auf dem Wafer.

Bei der Produktion von integrierten Halbleiterprodukten werden üblicherweise an einem Produktionsstandort eine Vielzahl von unterschiedlichen integrierten Halbleiterprodukten gleichzeitig hergestellt. Dies bedeutet, dass eine Vielzahl von Wafern mit unterschiedlich großen Chips sowie einer unterschiedlichen Anzahl von Chips gleichzeitig bearbeitet werden. Selbst wenn die unterschiedliche Halbleiterprodukte mit der selben Technologie, d.h. mit im wesentlichen dem gleichen Herstellungsverfahren hergestellt werden, können aufgrund der bisher verwendeten Analyseverfahren die Testergebnisse unterschiedlicher Halbleiterprodukte nicht direkt miteinander verglichen werden. Dies führt dazu, dass es häufig sehr lange dauert, bis Fehler im Herstellungsprozess erkannt werden können.

Der vorliegenden Erfindung liegt daher die Aufgabe zugrunde, ein Verfahren zur Fehleranalyse in der Waferfertigung bereitzustellen, das die beschriebenen Probleme vermindert bzw. ganz vermeidet. Der vorliegenden Erfindung liegt daher die Aufgabe zugrunde, ein Verfahren zur Fehleranalyse in der Waferfertigung bereitzustellen, das eine produktübergreifende Fehleranalyse ermöglicht.

Diese Aufgabe wird von dem erfindungsgemäßen Verfahren zur Fehleranalyse in der Waferfertigung gemäß des unabhängigen Patentanspruchs 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

US 5 991 699 A offenbart eine radial-symmetrische Wafermap mit nicht gleich grossen Normchips und Untersuchungen für nur ein Produkt. Die Analyse ist nur auf Geometriebedingte Fehler eines Produkts ausgerichtet.

Hess et al, "Wafer level defect density distribution using checkerboard test structures" vom 23. März 1998 (PROCEEDINGS OF THE 1998 INTERNATIONAL CONFERENCE ON MICROELECTRONIC TEST STRUCTURES, Vol. 11, S.101 ff, US 5 793 650 A, Friedmann et al, "Model-Free estimation of defect clustering in integrated circuit fabrication" IEEE TRANSACTIONS ON SEMICONDUCTOR MANUFACTURING, Bd. 10, Nr. 3, 1997, Seiten 344-359, US 2002/156550 B1, US 5 497 381, US 5 838 951 17 A und US 6 393 602 B1 offenbaren rechtwinklige Normchips, die gleich groß sind, aber von der Größe der untersuchten Chips abhängig sind, d.h. mit den untersuchten Chips identische Größe besitzen oder ein Vielfaches davon.

US 5 991 699 A offenbart gleich große Wafermap-Einheiten mit von den untersuchten Chips unabhängiger Größe, wobei aber nur einzelne Schaltungselemente und nicht die Funktionalität der Chips getestet wird.

Erfindungsgemäß wird ein Verfahren zur Fehleranalyse in der Waferfertigung mit folgenden Schritten bereitgestellt:

a) zumindest ein Wafer mit einer Vielzahl von Chips wird bereitgestellt,

b) die Chips werden zumindest hinsichtlich einer Eigenschaft untersucht,

c) die Ergebnisse der Untersuchung werden auf zumindest einen Normwafer mit einer vorgegebenen Anzahl von Normchips, die jeweils eine vorgegebene Größe aufweisen, übertragen, und

d) die übertragenen Ergebnisse werden ausgewertet.

Mit Hilfe des erfindungsgemäßen Verfahrens zur Fehleranalyse werden verschiedenste Chips mittels einer Transformation auf zumindest eine einheitliche vergleichbare Waferkarte ("Wafermap") mit gleich großen Normchips abgebildet. Durch diese Transformation bzw. Reskalierung wird eine chipflächenunabhängige Bewertung der Produkte bzw. der Herstellungsprozesse ermöglicht. Das erfindungsgemäßen Verfahren zur Fehleranalyse hat darüber hinaus den Vorteil, dass die so gewonnen Informationen sehr kompakt in entsprechenden Waferdatenbanken hinterlegt werden können und so für weitere Auswertungen zur Verfügung stehen.

Das erfindungsgemäße Verfahren ermöglicht die Durchführung von automatischen Wafermap-Vergleichen und damit die Durchführung von produktübergreifenden, wafermapspezifischen Analysen der Untersuchungsergebnisse. Wird das erfindungsgemäße Verfahren beispielsweise auf ähnliche Halbleiterprodukte angewandt (gleiche Zahl der kritischen Ebenen, gleiche Integrationsdichte der Schaltung, keine besonderen systematischen Fehler zwischen den Produkten), so würde man bei gleicher elektrischen wirksamen Defektdichte durch die Flächennormierung Ausbeutegleichheit zwischen den Produkten erwarten. Jede nun sofort sichtbare Abweichung davon, führt dann also auf einen zu erklärenden Beitrag und kann so zur Identifikation von Potentialen oder zur Erklärung von Defiziten beitragen.

Die Anwendung des erfindungsgemäßen Verfahrens ist dabei nicht auf das Gebiet der Halbleiterfertigung beschränkt. Auch in vielen anderen Technikbereichen, beispielsweise der Biotechnologie, werden heutzutage eine Vielzahl von gleichartigen aber unabhängigen Einheiten (Chips) gleichzeitig auf einem Träger (Wafer) hergestellt und auf die Einhaltung von vorgegebenen Spezifikationen untersucht. Dementsprechend kann das erfindungsgemäße Verfahren zur Fehleranalyse nicht nur in der Halbleiterfertigung sondern auch in anderen Technikbereichen sinnvoll eingesetzt werden.

Gemäß einer bevorzugten Ausführungsform des erfindungsgemäßen Verfahren wird zur Übertragung der Ergebnisse der Untersuchung auf den Normwafer jedem Normchip auf dem Normwafer mindestens ein Chip auf dem Wafer zugeordnet.

Dabei ist es insbesondere bevorzugt, wenn jeweils einem Chip auf dem Wafer der Normchip auf dem Normwafer zugeordnet wird, der den größten Flächenanteil des Chips überdeckt, wenn der Normwafer auf den Wafer projiziert wird. Weiterhin ist es bevorzugt, wenn jeweils einem Chip auf dem Wafer die Normchips auf dem Normwafer zugeordnet werden, die einen Flächenanteil des Chips überdecken, wenn der Normwafer auf den Wafer projiziert wird.

Gemäß einer weiteren bevorzugten Ausführungsform des erfindungsgemäßen Verfahrens werden einem Normchip alle Chips zugeordnet, deren Fläche der Normchip vollständig überdeckt, wenn der Normwafer auf den Wafer projiziert wird, und es werden einem Normchip nach dem Zufallsprinzip die Chips zugeordnet, deren Fläche der Normchip unvollständig überdeckt, wenn der Normwafer auf den Wafer projiziert wird. Dabei ist es insbesondere bevorzugt, wenn die Wahrscheinlichkeit, mit der ein Chip einem Normchip zugeordnet wird, proportional zu der von dem Normchip überdeckten Fläche auf dem Chip ist, wenn der Normwafer auf den Wafer projiziert wird.

Gemäß einer weiteren bevorzugten Ausführungsform des erfindungsgemäßen Verfahrens werden die Ergebnisse der Untersuchung auf den Normwafer übertragen, indem Ergebnisse für die Normchips aus den Ergebnissen der zugeordneten Chips bestimmt werden. Dabei ist es insbesondere bevorzugt, wenn ein Normchip ein bestimmtes Ergebnis aufweist, wenn zumindest einer der zugeordneten Chips das Ergebnis aufweist.

Gemäß einer weiteren bevorzugten Ausführungsform des erfindungsgemäßen Verfahrens weist ein Normchip ein bestimmtes Ergebnis auf, wenn eine gewichtete Summe der Ergebnisse der zugeordneten Chips ein vorgegebenes Kriterium erfüllt. Dabei ist es insbesondere bevorzugt, wenn die gewichtete Summe der Ergebnisse anhand der überdeckten Flächenanteile der dem Normchip zugeordneten Chips bestimmt wird.

Gemäß einer weiteren bevorzugten Ausführungsform des erfindungsgemäßen Verfahrens wird zumindest ein bestimmtes Ergebnis nach dem Zufallsprinzip von den dem jeweiligen Normchip zugeordneten Chips auf den Normchip übertragen. Dabei ist es insbesondere bevorzugt, wenn die Wahrscheinlichkeit, mit der das bestimmte Ergebnis auf den Normchip übertragen wird, von der Summe der von dem Normchip überdeckten Flächenanteile der Chips abhängt, die das bestimmte Ergebnis aufweisen. Weiterhin ist es bevorzugt, dass das bestimmte Ergebnis sicher auf den Normchip übertragen wird, wenn die Summe der von dem Normchip überdeckten Flächenanteile der Chips, die das bestimmte Ergebnis aufweisen, größer oder gleich der Fläche eines vollständigen Chips auf dem Wafer ist.

Gemäß einer weiteren bevorzugten Ausführungsform des erfindungsgemäßen Verfahren werden die Chips hinsichtlich ihrer Funktionstüchtigkeit untersucht. Dementsprechend ist es bevorzugt, aus den Untersuchungsergebnissen die Ausbeute zu bestimmen. Die dann durch das erfindungsgemäße Verfahren gewonnene, flächennormierte Ausbeute bietet sich als effizientes Monitorinstrument an, z.B. zur Überwachung der Fertigungsgüte und auch der Fertigungsstabilität. Weiterhin ist es bevorzugt, zur Auswertung die elektrisch wirksame Defektdichte zu bestimmen.

Die Erfindung wird nachfolgend anhand von Figuren der Zeichnung näher dargestellt. Es zeigen:

Fig. 1    einen Teilbereich eines Wafers, auf den ein erfindungsgemäßes Verfahren zur Fehleranalyse angewandt wird,

Fig. 2    einen Teilbereich eines Wafers, auf den ein entsprechender Teilbereich eines Normwafers projiziert ist,

Fig. 3    einen vollständigen Wafer, mit den Ergebnissen eines Funktionstest, und

Fig. 4    einen vollständigen Normwafer, mit den entsprechend übertragenen Ergebnissen eines Funktionstest.

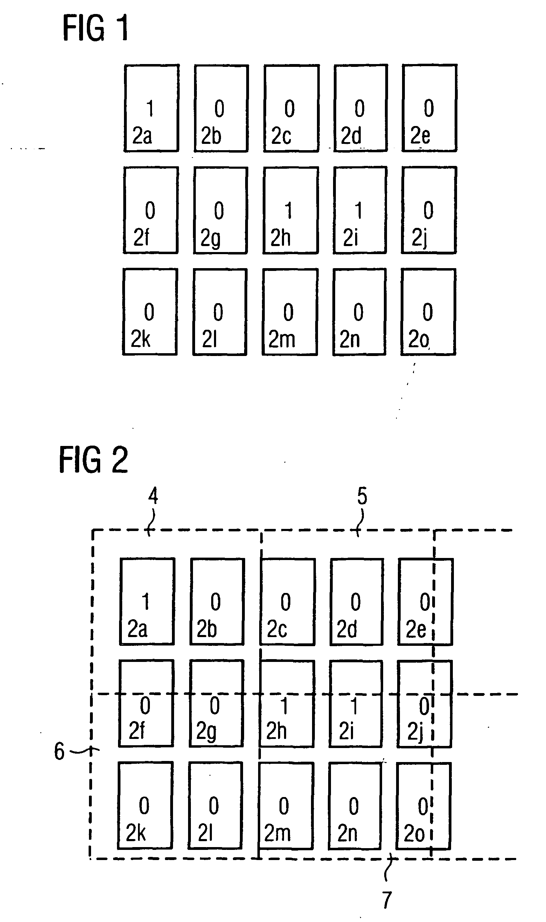

Fig. 1 zeigt einen Teilbereich eines Wafers, auf den ein erfindungsgemäßes Verfahren zur Fehleranalyse angewandt wird. Auf dem Wafer sind eine Vielzahl von gleichartigen aber von einander unabhängigen Chips 2a bis 2o angeordnet. Im vorliegenden Beispiel handelt es sich bei den Chips 2a bis 2o um integrierten Schaltungen bzw. integrierte Halbleiterprodukte, die nach Fertigstellung auf ihre Funktionstüchtigkeit getestet werden. Diese Test werden üblicherweise zu einem Zeitpunkt durchgeführt, an dem die Chips noch auf dem Wafer angeordnet sind und der Wafer noch nicht zersägt wurde.

Besteht ein Chip diesen Test wird ihm der Wert 0 zugeordnet. Wird bei dem Test ein Funktionsfehler des Chips festgestellt, so wird den entsprechenden Chips der Wert 1 zugeordnet. Das in Fig. 1 gezeigte Beispiel enthält somit 3 fehlerhafte Chips 2a, 2h und 2i. Üblicherweise werden die fehlerhaften Chips nach den Tests markiert, so daß sie nach dem Zersägen des Wafers aussortiert werden können.

Die Größe der Chips 2a bis 2o hängt sowohl von Art und Typ des hergestellten Halbleiterprodukts als auch dem verwendeten Herstellungsprozeß (Technologiegeneration) ab. Die unterschiedliche Größe der Chips hat natürlich zur Folge, daß auch die Zahl der Chips pro Wafer von der Art und Typ des hergestellten Halbleiterprodukts sowie von dem verwendeten Herstellungsprozeß abhängt. Aufgrund der unterschiedlichen Größe der Chips sowie der unterschiedlichen Anzahl der Chips pro Wafer konnten bei den bisher eingesetzten Verfahren zur Fehleranalyse nur unzureichend produktübergreifende Analysen durchgeführt werden.

Um produktübergreifende Fehleranalysen zu ermöglichen, werden nun die Ergebnisse der Funktionstests auf zumindest einen Normwafer mit einer vorgegebenen Anzahl von Normchips, die jeweils eine vorgegebene Größe aufweisen, übertragen. Dabei ist es insbesondere bevorzugt, wenn zur Übertragung der Ergebnisse der Funktionstests jedem Normchip auf dem Normwafer mindestens ein Chip auf dem Wafer zugeordnet wird. Fig. 2 zeigt den in Fig. 1 gezeigten Teilbereich des Wafers, auf den ein entsprechender Teilbereich eines Normwafers mit den Normchips 4, 5, 6 und 7 projiziert ist.

Gemäß einer ersten Ausführungsform des erfindungsgemäßen Verfahrens wird die Zuordnung zwischen Chips 2a bis 2o und den Normchips 4, 5, 6 und 7 auf eine Weise durchgeführt, daß jeweils einem Chip auf dem Wafer der Normchip auf dem Normwafer zugeordnet, der den größten Flächenanteil des Chips überdeckt, wenn der Normwafer auf den Wafer projiziert wird. Bei dem in Fig. 2 gezeigten Beispiel bedeutet dies, dass den Chips 2a und 2b der Normchip 4 zugeordnet ist. Desweiteren sind die Chips 2c, 2d und 2e dem Normchip 5 und die Chips 2f, 2g, 2k sowie 2l dem Normchip 6 zugeordnet. Schließlich sind die Chips 2h, 2i, 2j, 2m, 2n und 2o dem Normchip 7 zugeordnet.

Die Ergebnisse der Funktionstests werden nun auf den Normwafer übertragen, indem die Ergebnisse für die Normchips aus den Ergebnissen der zugeordneten Chips bestimmt werden. So weist in einer Ausführungsform des erfindungsgemäßen Verfahrens ein Normchip ein bestimmtes Ergebnis auf, wenn zumindest einer der ihm zugeordneten Chips das Ergebnis aufweist. Im vorliegenden Beispiel wird als das bestimmte Ergebnis die Fehlerhaftigkeit der Chips gewählt. Daraus folgt, dass im vorliegenden Beispiel der Normchip 4 als fehlerhaft (Wert = 1) gewertet wird, da der ihm zugeordnete Chip 2a fehlerhaft ist. Weiterhin werden die Normchips 5 und 6 als nicht fehlerhaft (Wert = 0) gewertet, da keiner der ihnen zugeordneten Chips fehlerhaft ist. Der Normchip 7 hingegen wird wieder als fehlerhaft (Wert = 1) gewertet, da die ihm zugeordneten Chips 2h bzw. 2i fehlerhaft sind.

Aus den übertragenen Ergebnissen kann nun beispielsweise das Verhältnis der Anzahl der fehlerfreien Normchips zu der Gesamtzahl der Normchips bestimmt werden. Diese Verhältnis entspricht einer flächennormierten Ausbeute Y_fn, welche sich als effizientes Monitorinstrument an, z.B. zur Überwachung der Fertigungsgüte und auch der Fertigungsstabilität, anbietet.

Gemäß einer weiteren Ausführungsform des erfindungsgemäßen Verfahrens wird die Zuordnung zwischen Chips 2a bis 2o und den Normchips 4, 5, 6 und 7 auf eine Weise durchgeführt, daß einem Normchip alle Chips zugeordnet werden, deren Fläche der Normchip vollständig überdeckt, und einem Normchip nach dem Zufallsprinzip die Chips zugeordnet werden, deren Fläche der Normchip nur unvollständig überdeckt.

Bei dem in Fig. 2 gezeigten Beispiel könnte dies bedeuten, dass den Chips 2a, 2b und, auf Grund des Zufallsprinzips, dem Chip 2f der Normchip 4 zugeordnet ist. Desweiteren sind die Chips 2c, 2d und, auf Grund des Zufallsprinzips, die Chips 2e und 2h dem Normchip 5 und die Chips 2k, 2l dem Normchip 6 zugeordnet. Schließlich sind die Chips 2m, 2n und, auf Grund des Zufallsprinzips, die Chips 2i, 2j und 2o dem Normchip 7 zugeordnet. Bei einer derartigen zum Teil auf Zufall basierenden Zuordnung zwischen den Chips und den Normchips kann es vorkommen, dass einem oder mehreren Chips, in diesem Fall dem Chip 2g, kein Normchip zugeordnet wird. Sind jedoch die Normchips ausreichend groß gegenüber den Chips gewählt, ist sicher gestellt, dass jedem Normchip zumindest ein Chip zugeordnet wird.

Die Ergebnisse der Funktionstests werden nun auf den Normwafer übertragen, wobei ein Normchip wiederum ein bestimmtes Ergebnis aufweist, wenn zumindest einer der ihm zugeordneten Chips das Ergebnis aufweist. Daraus folgt, dass im vorliegenden Beispiel der Normchip 4 als fehlerhaft (Wert = 1) gewertet wird, da der ihm zugeordnete Chip 2a fehlerhaft ist. Weiterhin wird nun auch der Normchips 5 als fehlerhaft (Wert = 1) gewertet, da der ihm per Zufall zugeordnete Chip 2h fehlerhaft ist. Der Normchip 6 wird als fehlerfrei gewertet, da keiner der ihm zugeordneten Chip fehlerhaft ist. Der Normchip 7 hingegen wird wieder als fehlerhaft (Wert = 1) gewertet, da der ihm per Zufall zugeordnete Chip 2i fehlerhaft ist.

Eine derartige, zum Teil zufällige Zuordnung zwischen den Normchips und den Chips kann beispielsweise durch eine Koordinatentransformation erfolgen, die zwischen den Koordinaten (Intervalllänge 1) der Chips und den Koordinaten der Normchips umrechnet und die den Aufruf einer Zufallsfunktion enthält. So können allgemein die Koordinaten des Normwafers im Raster x_neu_min, x_neu_max, y_neu_min und y_neu_max aufgebaut werden. Weiterhin kann auch der gegebene, reale Wafer allgemein durch ein Raster x_min, x_max, y_min und y_max einteilt werden.

Mit der Formeln:

```
x_neu =
     round((x - x_min + random)*
     (x_neu_max - x_neu_min + 1)/(x_max - x_min + 1) - 0,5)
      + x_neu_min
```

und

```
y_neu =
     round((y - y_min + random)*
     (y_neu_max - y_neu_min + 1)/(y_max - y_min + 1) - 0,5)
      + y_neu_min
```

werden aus den Koordinaten des Chips die entsprechenden Koordinaten des Normchips berechnet. Die Funktion "random" erzeugt dabei gleichverteilte Zufallszahlen im Intervall (0, 1). Durch diese Vorschrift wird ein Chip mit den Koordinaten x, y exakt nur einem Normchip mit den Koordinaten x_neu, y_neu gemäß der entsprechenden Flächenanteilswahrscheinlichkeit zugeordnet.

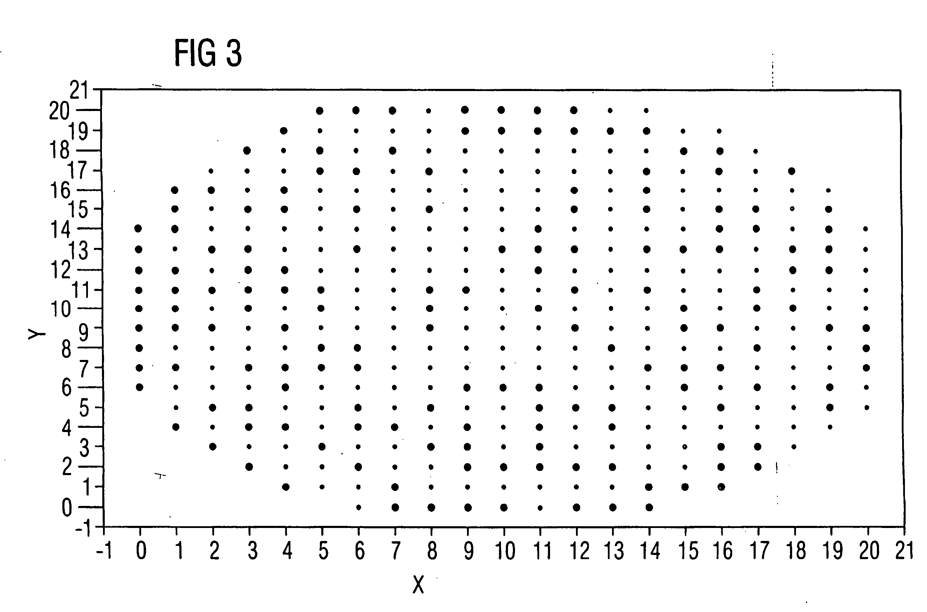

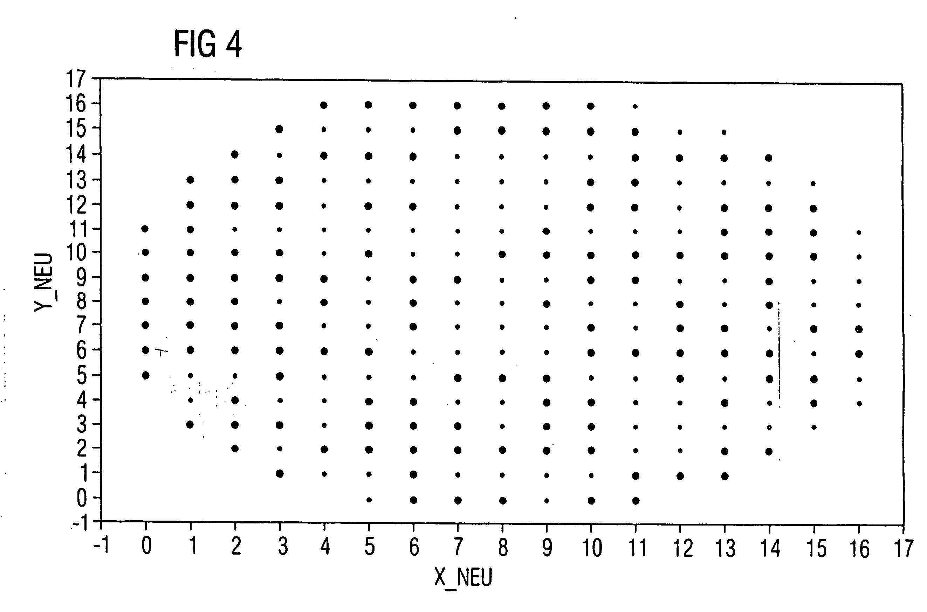

Die Auswirkungen dieser Transformation sind beispielhaft in den Figuren 3 und 4 gezeigt. Fig. 3 zeigt schematisch einen vollständigen Wafer mit nahezu 400 Chips. Weiterhin sind in Fig. 3 die Ergebnisse eines Funktionstest durch die unterschiedlich großen Punkte angedeutet. Dabei steht ein großer Punkt für einen fehlerhaften Chip während ein kleiner Punkt einen fehlerfreien Chip steht.

Fig. 4 zeigt schematisch einen vollständigen Normwafer, mit den entsprechend übertragenen Ergebnissen eines Funktionstest. Die Zuordnung der Chips zu den Normchips erfolgte mit Hilfe der oben beschriebenen Koordinatentransformation. Ein Normchip wurde dabei als fehlerhaft angesehen, wenn zumindest einer der ihm zugeordneten Chips fehlerhaft ist. Man erhält auf diese Weise eine flächennormierte Waferkarte (Wafermap), die einer weiteren statistischen Analyse zur Verfügung steht. Die so gewonnen Daten können nun zu den bereits vorhandenen Daten auf Waferebene hinzugenommen werden oder entsprechend verdichtet ausgewertet werden.

Gemäß einer weiteren Ausführungsform des erfindungsgemäßen Verfahrens wird die Zuordnung zwischen Chips 2a bis 2o und den Normchips 4, 5, 6 und 7 auf eine Weise durchgeführt, daß jeweils einem Chip auf dem Wafer die Normchips auf dem Normwafer zugeordnet werden, die einen Flächenanteil des Chips überdecken, wenn der Normwafer auf den Wafer projiziert wird.

Bei dem in Fig. 2 gezeigten Beispiel bedeutet dies, dass dem Normchip 4 die Chips 2a, 2b, 2f und 2g zugeordnet sind. Desweiteren sind dem Normchip 5 die Chips 2c, 2d, 2e, 2h, 2i sowie 2j und dem Normchip 6 die Chips 2f, 2g, 2k sowie 2l zugeordnet. Schließlich sind die Chips 2h, 2i, 2j, 2m, 2n und 2o dem Normchip 7 zugeordnet. Dementsprechend sind bei dieser Ausführungsform des Verfahrens manchen Chips mehr als ein Normchip zugeordnet.

Die Ergebnisse der Funktionstests werden nun wiederum auf den Normwafer übertragen, wobei ein Normchip ein bestimmtes Ergebnis aufweist, wenn eine gewichtete Summe der Ergebnisse der zugeordneten Chips ein vorgegebenes Kriterium erfüllt. Dabei ist es insbesondere bevorzugt, wenn die gewichtete Summe der Ergebnisse anhand der überdeckten Flächenanteile der dem Normchip zugeordneten Chips bestimmt wird. Wird beispielsweise als Kriterium verwendet, dass die gewichtete Summe größer oder gleich Eins ist, so hat dies zur Folge, dass der Normchip 4 als fehlerhaft gewertet wird, da der Chip 2a fehlerhaft ist und dieser Chip im bezug auf den Normchip 4 zu 100% in die gewichtete Summe eingeht. Dementsprechend ist bereits durch den Beitrag von Chip 2a zur gewichteten Summe das Kriterium erfüllt.

Hingegen wird Normchip 5 als fehlerfrei gewertet. Die dem Normchip 5 zugeordneten Chips 2h und 2i liefern zwar eine positiven Beitrag zu der gewichteten Summe. Ihre Flächenanteile in Bezug auf Normchip 5 sind jedoch zu klein als dass das Kriterium (Summe größer als Eins) erfüllt werden könnte. Der Normchip 6 wird als fehlerfrei gewertet, weil keiner der ihm zugeordneten Chips einen positiven Beitrag zu der Summe liefert. Der Normchip 7 wird hingegen als fehlerhaft gewertet, weil die entsprechende gewichtete Summe durch die Beiträge der Chips 2h und 2i größer als Eins wird.

Gemäß einer weiteren Ausführungsform des erfindungsgemäßen Verfahrens wird die Zuordnung zwischen Chips 2a bis 2o und den Normchips 4, 5, 6 und 7 wiederum auf eine Weise durchgeführt, daß jeweils einem Chip auf dem Wafer die Normchips auf dem Normwafer zugeordnet werden, die einen Flächenanteil des Chips überdecken, wenn der Normwafer auf den Wafer projiziert wird.

Im Gegensatz zu der vorhergehenden Ausführungsform werden die Ergebnisse nicht in Form einer gewichteten Summe auf die Normchips übertragen sondern zumindest ein bestimmtes Ergebnis wird nach dem Zufallsprinzip von den dem jeweiligen Normchip zugeordneten Chips auf den Normchip übertragen. Im vorliegenden Beispiel ist das bestimmte Ergebnis wiederum die Fehlerhaftigkeit (Wert = 1) der Chips.

Dabei ist es insbesondere bevorzugt, wenn die Wahrscheinlichkeit, mit der dieses Ergebnis (Wert = 1) auf den Normchip übertragen wird, von der Summe der von dem Normchip überdeckten Flächenanteile der Chips abhängt, die das bestimmte Ergebnis aufweisen. Weiterhin ist es bevorzugt, dass das bestimmte Ergebnis sicher auf den Normchip übertragen wird, wenn die Summe der von dem Normchip überdeckten Flächenanteile der Chips, die das bestimmte Ergebnis aufweisen, größer oder gleich der Fläche eines vollständigen Chips auf dem Wafer ist.

Bei dem in Fig. 2 gezeigten Beispiel ergibt sich somit, dass der Normchip 4 als fehlerhaft gewertet wird, da der Chip 2a fehlerhaft ist und seine gesamte Fläche von dem Normchip 4 überdeckt wird. Dementsprechend wird der Wert 1 sicher, d.h. mit Wahrscheinlichkeit 1, auf den Normwafer übertragen. Der Normchip 5 wird mit einer gewissen Wahrscheinlichkeit ($p \approx 0,6$) als fehlerhaft gewertet, da die Summe der Flächenteile der Chips 2h und 2i, die von dem Normwafer 5 überdeckt werden, 60% der Fläche eines vollständige Chips ausmacht. Sollte bei einer Durchführung des Verfahrens per Zufallsgenerator das Ergebnis 1 nicht auf den Normchip 5 übertragen werden, so das Ergebnis 0 als sogenannter "Default-Wert" auf den Normchip 5 übertragen und dementsprechend der Normchip 5 als fehlerfrei gewertet.

Der Normchip 6 wird als fehlerfrei gewertet, weil keiner der ihm zugeordneten Chips als fehlerhaft gewertet wird. Der Normchip 7 wird hingegen als fehlerhaft gewertet, weil die Chips 2h und 2i fehlerhaft sind und die Summe ihrer vom Normchip 7 überdeckten Flächenanteile größer als die Fläche eines Chips ist. Dementsprechend wird der Wert 1 sicher, d.h. mit Wahrscheinlichkeit 1, auf den Normwafer 7 übertragen.

Durch die Einführung eines Normwafer mit Normchips und der damit verbundenen Flächennormierung bzw. den damit verbundenen flächennormierten Waferkarten werden produktübergreifende Vergleiche von Waferkarten ermöglicht. Weiterhin wird durch die Einführung eines Normwafer mit Normchips das Erkennen von Abweichungen, die durch Design, Prüftechnik, Technologie, Prozess und Fertigung hervorgerufen werden, wesentlich erleichtert. Die mit Hilfe des Normwafer bestimmbare flächennormierte Ausbeute kann als Monitor für den sogenannten "Yield" ("Yield-Performance") dienen. Dabei können hinsichtlich dem Mittelwert und der Streuung Aussagen getroffen werden.

Durch die Einführung eines Normwafer mit Normchips und der damit verbundenen Flächennormierung bzw. den damit verbundenen flächennormierten Waferkarten können technologische Unterschiede verschiedener Prozessgruppen ausgedrückt werden. Beispielsweise läßt sich das Produkt aus der Zahl n, der angenommen kritischen Ebenen, und D, der zugehörigen elektrisch wirksamen Defektdichte an Hand der folgenden Formel berechnen:

$$K * n * D = - ln(Y\_fn)/A\_fn$$

wobei Y_fn die flächennormierte Ausbeute, A_fn die Normfläche der Normchips und K die Integrationsdichte der Chips beschreiben.

Weiterhin wird durch das erfindungsgemäße Verfahren die Korrelation zu Defektdichte-Daten wesentlich erleichtert. Insbesondere kann die flächennormierte Ausbeute Y_fn leicht mit theoretisch errechneten Verteilungen errechnet werden.

**Patentansprüche**

1. Verfahren zur Fehleranalyse in der Waferfertigung unterschiedlicher Chip-Produkte mit den Schritten

    a) zumindest ein Wafer mit einer Vielzahl von Chips wird bereitgestellt,
    b) die Chips werden hinsichtlich ihrer Funktionstüchtigkeit untersucht,
    c) die Ergebnisse der Untersuchung werden zur Gewinnung einer einheitlichen, vergleichbaren Waferkarte auf zumindest einen Normwafer mit einer vorgegebenen Anzahl von gleich großen Normchips, die eine vorgegebene, von der Fläche der untersuchten Chips unabhängige Größe aufweisen, übertragen, und
    d) die übertragenen Ergebnisse werden produktübergreifend ausgewertet.

2. Verfahren nach Anspruch 1,
   **dadurch gekennzeichnet, daß**
   zur Übertragung der Ergebnisse der Untersuchung auf den Normwafer jedem Normchip auf dem Normwafer mindestens ein Chip auf dem Wafer zugeordnet wird.

3. Verfahren nach Anspruch 2,
   **dadurch gekennzeichnet, daß**
   jeweils einem Chip auf dem Wafer der Normchip auf dem Normwafer zugeordnet wird, der den größten Flächenanteil des Chips überdeckt, wenn der Normwafer auf den Wafer projiziert wird.

4. Verfahren nach Anspruch 2,
   **dadurch gekennzeichnet, daß**
   jeweils einem Chip auf dem Wafer die Normchips auf dem Normwafer zugeordnet werden, die einen Flächenanteil des Chips überdecken, wenn der Normwafer auf den Wafer projiziert wird.

5. Verfahren nach Anspruch 2,
   **dadurch gekennzeichnet, daß**
   einem Normchip alle Chips zugeordnet werden, deren Fläche der Normchip vollständig überdeckt, wenn der Normwafer auf den Wafer projiziert wird, und einem Normchip nach dem Zufallsprinzip die Chips zugeordnet werden, deren Fläche der Normchip unvollständig überdeckt, wenn der Normwafer auf den Wafer projiziert wird.

6. Verfahren nach einem der Ansprüche 2 bis 5,
   **dadurch gekennzeichnet, daß**
   die Ergebnisse der Untersuchung auf den Normwafer übertragen werden, indem die Ergebnisse für die Normchips aus den Ergebnissen der zugeordneten Chips bestimmt werden.

7. Verfahren nach Anspruch 6,
   **dadurch gekennzeichnet, daß**
   ein Normchip ein bestimmtes Ergebnis aufweist, wenn zumindest einer der zugeordneten Chips das Ergebnis aufweist.

8. Verfahren nach Anspruch 6,
   **dadurch gekennzeichnet, daß**

ein Normchip ein bestimmtes Ergebnis aufweist, wenn eine gewichtete Summe der Ergebnisse der zugeordneten Chips ein vorgegebenes Kriterium erfüllt.

**9.** Verfahren nach Anspruch 8,
**dadurch gekennzeichnet, daß**
die gewichtete Summe der Ergebnisse anhand der überdeckten Flächenanteile der dem Normchip zugeordneten Chips bestimmt wird.

**10.** Verfahren nach Anspruch 6,
**dadurch gekennzeichnet, daß**
zumindest ein bestimmtes Ergebnis nach dem Zufallsprinzip von den dem jeweiligen Normchip zugeordneten Chips auf den Normchip übertragen wird.

**11.** Verfahren nach Anspruch 10,
**dadurch gekennzeichnet, daß**
die Wahrscheinlichkeit, mit der das bestimmte Ergebnis auf den Normchip übertragen wird, von der Summe der von dem Normchip überdeckten Flächenanteile der Chips abhängt, die das bestimmte Ergebnis aufweisen.

**12.** Verfahren nach einem der vorhergehenden Ansprüche,
**dadurch gekennzeichnet, daß**
zur Auswertung die Ausbeute an funktionierenden Chips pro Fläche bestimmt wird.

**13.** Verfahren nach einem der vorhergehenden Ansprüche,
**dadurch gekennzeichnet, daß**
zur Auswertung die Defektdichte bestimmt wird.


**Claims**

**1.** Method for fault analysis in wafer production of various chip products having the following steps:

   a) at least one wafer with a multiplicity of chips is provided,
   b) the chips are examined with regard to their functionality,
   c) in order to obtain a uniform, comparable wafer map, the results of the examination are transferred to at least one standard wafer with a predetermined number of standard chips of identical size which each have a predetermined size independent of the area of the examined chips, and
   d) the transferred results are evaluated in cross-product fashion.

**2.** Method according to Claim 1,
**characterized in that**
in order to transfer the results of the examination to the standard wafer, each standard chip on the standard wafer is assigned at least one chip on the wafer.

**3.** Method according to Claim 2,
**characterized in that**
a respective chip on the wafer is assigned the standard chip on the standard wafer which covers the largest proportion of the area of the chip if the standard wafer is projected onto the wafer.

**4.** Method according to Claim 2,
**characterized in that**
a respective chip on the wafer is assigned the standard chips on the standard wafer which cover a proportion of the area of the chip if the standard wafer is projected onto the wafer.

**5.** Method according to Claim 2,
**characterized in that**
a standard chip is assigned all the chips whose area is completely covered by the standard chip if the standard wafer is projected onto the wafer, and a standard chip is assigned, according to the random principle, the chips whose area is incompletely covered by the standard chip if the standard wafer is projected onto the wafer.

**6.** Method according to one of Claims 2 to 5,
**characterized in that**
the results of the examination are transferred to the standard wafer by the results for the standard chips being determined from the results of the assigned chips.

**7.** Method according to Claim 6,
**characterized in that**
a standard chip has a specific result if at least one of the assigned chips has the result.

**8.** Method according to Claim 6,
**characterized in that**
a standard chip has a specific result if a weighted sum of the results of the assigned chips fulfills a predetermined criterion.

**9.** Method according to Claim 8,
**characterized in that**
the weighted sum of the results is determined using the covered proportions of the area of the chips assigned to the standard chip.

**10.** Method according to Claim 6,
**characterized in that**
at least one specific result is transferred according to the random principle from the chips assigned to the respective standard chip to the standard chip.

**11.** Method according to Claim 10,
**characterized in that**
the probability with which the specific result is transferred to the standard chip depends on the sum of the proportions of the area - covered by the standard chip - of the chips which have the specific result.

**12.** Method according to one of the preceding claims,
**characterized in that**
the yield of functioning chips per area is determined for the evaluation.

**13.** Method according to one of the preceding claims,
**characterized in that**
the defect density is determined for the evaluation.


**Revendications**

**1.** Procédé pour analyser les défauts dans la fabrication des tranches de différents produits de puce, comportant les étapes suivantes

a) se procurer au moins une tranche munie d'une pluralité de puces,
b) examiner les puces quant à leur capacité à fonctionner,
c) reporter, afin d'obtenir une carte de tranches homogène et comparable, les résultats de l'examen sur au moins une tranche étalon équipée d'un nombre prédéfini de puces étalon de même taille, qui ont ene taille prédéfinie, indépendante de la surface des puces examinées et
d) exploiter au-delà du produit les résultats reportés.

**2.** Procédé selon la revendication 1, **caractérisé en ce que**, pour reporter les résultats de l'examen sur la tranche étalon, on associe au moins une puce située sur la tranche à chaque puce étalon située sur la tranche étalon.

**3.** Procédé selon la revendication 2, **caractérisé en ce qu'**on associe à une puce située sur la tranche la puce étalon, située sur la tranche étalon, qui recouvre la plus grande proportion superficielle de la puce quand on projette la tranche étalon sur la tranche.

**4.** Procédé selon la revendication 2, **caractérisé en ce qu'**on associe à une puce située sur la tranche les puces étalon, situées sur la tranche étalon, qui recouvrent une proportion superficielle de la puce quand on projette la tranche étalon sur la tranche.

5. Procédé selon la revendication 2, **caractérisé en ce qu'**on associe à une puce étalon toutes les puces dont la surface est entièrement recouverte par la puce étalon quand on projette la tranche étalon sur la tranche et qu'on associe d'après le principe aléatoire à une puce étalon les puces dont la surface n'est pas entièrement recouverte par la puce étalon quand on projette la tranche étalon sur la tranche.

6. Procédé selon l'une des revendications 2 à 5, **caractérisé en ce que** les résultats de l'examen sont reportés sur la tranche étalon en déterminant à partir des résultats des puces associées les résultats pour les puces étalon.

7. Procédé selon la revendication 6, **caractérisé en ce qu'**une puce étalon a un résultat donné quand au moins une des puces associées présente le résultat en question.

8. Procédé selon la revendication 6, **caractérisé en ce qu'**une puce étalon a un résultat donné quand une somme pondérée des résultats des puces associées remplit un critère prédéfini.

9. Procédé selon la revendication 8, **caractérisé en ce que** la somme pondérée des résultats est déterminée à l'aide des proportions superficielles recouvertes des puces associées à la puce étalon.

10. Procédé selon la revendication 6, **caractérisé en ce qu'**on reporte sur la puce étalon d'après le principe aléatoire au moins un résultat donné provenant des puces associées à la puce étalon correspondante.

11. Procédé selon la revendication 10, **caractérisé en ce que** la probabilité que le résultat donné soit reporté sur la puce étalon dépend de la somme des proportions superficielles - des puces - qui sont recouvertes par la puce étalon et ont le résultat donné.

12. Procédé selon l'une des revendications précédentes, **caractérisé en ce que** pour l'exploitation on détermine par unité de surface le rendement sur les puces qui fonctionnent.

13. Procédé selon l'une des revendications précédentes, **caractérisé en ce que** pour l'exploitation on détermine la fréquence des défauts.

## FIG 1

## FIG 2

FIG 3

EP 1 333 293 B1

# FIG 4